# EUROPEAN PATENT APPLICATION

(11) **EP 0 545 585 A2**
(43) Date of publication of application: **09.06.1993**
(21) Application number: 92310586.0
(22) Date of filing: 19.11.1992
(51) Int. Cl.: H01L 21/32, H01L 21/76

(54) **Integrated circuit fabrication comprising a LOCOS process**

(30) Priority: 03.12.1991 US 801236
(71) Applicant: AT&T Corp., New York, NY 10013-2412 (US)
(72) Inventor: Lee, Kuo-Hua, Wescosville, Pennsylvania 18106 (US); Yu, Chen-Hau Douglas, Allentown, Pennsylvania 18103 (US)
(74) Representative: Johnston, Kenneth Graham

(57) **Abstract**

A method of semiconductor integrated circuit fabrication is disclosed. An amorphous silicon layer (e.g., 15) is deposited between an oxide layer (e.g., 13) and a nitride layer (e.g., 17) in an improved poly buffered LOCOS process. When the amorphous silicon (e.g., 15) is oxidized it provides a field oxide (e.g., 23) with a smoother upper surface.

## Description

### Technical Field

This invention relates to methods for fabricating semiconductor integrated circuits.

### Background of the Invention

Typical silicon integrated circuit fabrication involves the formation of isolation regions termed "field oxides" between individual transistors. Typically, a patterned bilayer of oxide and nitride is formed upon a silicon substrate. Then the substrate is subjected to an oxidation process in which exposed areas of silicon are converted to silicon dioxide. The process is often termed the "LOCOS" process or the "local oxidation of silicon" process.

An improvement upon the LOCOS process is the poly buffered process or "PBL." In the conventional PBL process, a layer of polysilicon is formed between the oxide and the nitride. Polysilicon is patterned together with the nitride. The polysilicon layer helps to relieve stresses generated during subsequent field oxide growth.

In some PBL processes, for example that disclosed in Hayden et al., A High Performance Half-Micrometer Generation CMOS Technology for Fast SRAMSs, IEEE Transactions on Electron Devices, Vol. 38, No. 4, pages 876-886, April 1991, the polysilicon layer is not removed prior to field oxide formation, but is instead also oxidized as part of the field oxide formation process. However, both conventional PBL processes (which remove polysilicon prior to field oxide formation) and the Hayden et al. process mentioned above create a field oxide which exhibits a rough upper surface punctuated by many small pits.

### Summary of the Invention

The present invention utilizes amorphous silicon instead of polycrystalline silicon to alleviate the difficulties described above. Illustratively, the invention includes a process of forming a layer of amorphous silicon overlying a substrate. A patterned layer is formed overlying the layer of amorphous silicon; the patterned layer exposes portions of the amorphous silicon layer. Then the exposed portions of amorphous silicon are oxidized.

The precise mechanism responsible for the rough surface and pits is not understood. However, these surface imperfections in the field oxide may cause various problems in subsequent processing. For example, the imperfections in the field oxide may cause spurious reflections of light into the photoresist which is subsequently deposited and used to define the gate. These reflections are manifested as rough edges in the sides of the patterned photoresist. The rough edges in the photoresist are then transferred downward into the gate, creating an undesirable phenomenon termed "gate notching."

In addition, the surface imperfections in the field oxide create a rough topography which adversely affects the quality of subsequently-deposited layers.

### Brief Description of the Drawings

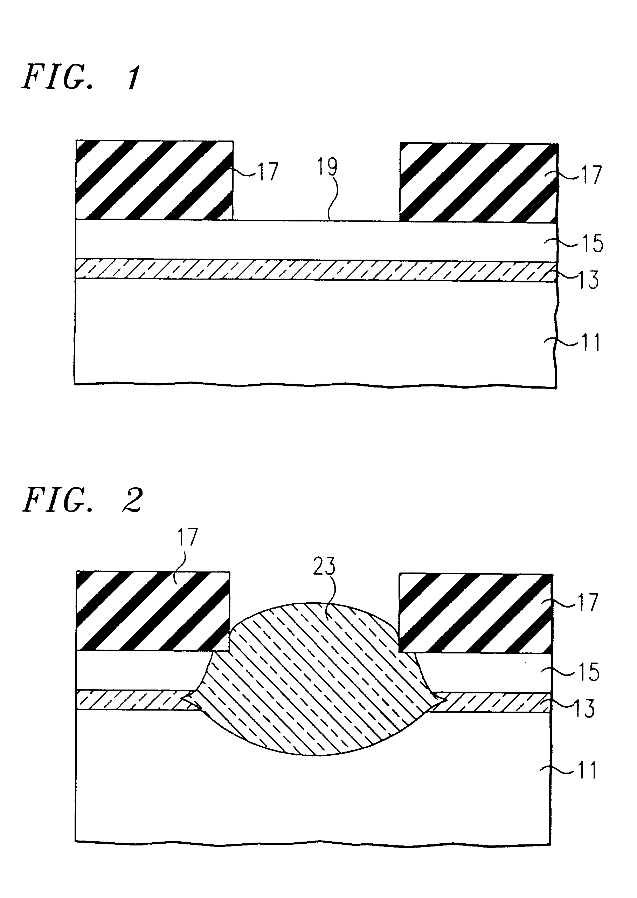

FIGS. 1 and 2 are cross-sectional views of an illustrative embodiment of the present invention.

### Detailed Description

In FIG. 1, reference numeral 11 denotes a substrate which may be, typically, silicon, doped silicon, epitaxial silicon, etc. In general, the term substrate refers to any material with a surface upon which other materials may be grown or formed. Reference numeral 13 denotes an oxide layer. Reference numeral 15 denotes an amorphous silicon layer. By contrast with the conventional PBL process, the present invention features the use of amorphous silicon instead of conventional polycrystalline silicon. Reference numeral 17 denotes a patterned silicon nitride layer.

Typically, the thickness of oxide layer 13 is 150-300A. The thickness of amorphous silicon layer 15 is 500 - 800A. The thickness of nitride layer 17 is 2100-2400A. Other thicknesses may be used.

Amorphous silicon layer 15 is conventionally formed by the decomposition of silane or disilane. The decomposition takes place preferably in a temperature below 575 °C. (At temperatures appreciably above 575 °C, polycrystalline silicon is formed.) Desirably, applicants have found that layer 15 is formed at a temperature of 550°C±10°. The deposition rate of amorphous silicon is somewhat slower than the deposition rate of polysilicon. Typically, amorphous silicon layer 15 deposits at approximately 22A per minute, whereas, by contrast, a typical polycrystalline silicon layer may deposit at 34A per minute. For the thicknesses of interest, the processing times may be roughly 35 minutes as contrasted with 20 minutes, a difference of 15 minutes. Upper surface 19 of amorphous layer 15 is generally smoother than the corresponding upper surface of a polycrystalline layer. Thus, there is less possibility of holes or pits on the amorphous surface 19 which may cause problems later.

Furthermore, layer 15 is not removed after silicon nitride layer 17 is patterned.

Turning to FIG. 2, field oxide 21 is formed by oxidation either in dioxygen or steam or by high pressure oxidation. As mentioned before, layer 15 is not removed prior to field oxide 21 formation. The amorphous silicon is substantially completely oxidized. Some slight oxidation in region 100 of amorphous layer 15 under layer 17 is observed.

The use of amorphous silicon is preferable to the use of polysilicon. Were layer 15 made from polysilicon, there would be small pits in the upper surface of the polysilicon. The field oxide 21 produced by applicants' process, which employs amorphous silicon, has a smoother upper surface 23. The smooth upper surface has a tendency to reflect less light during photolithography towards subsequently formed gates. Applicants believe that light reflected from rough-edged surface field oxides formed by the use of polysilicon may tend to cause gate notching of the photoresist which defines the gate.

Furthermore, applicants' experimental data show that amorphous silicon tends to produce smaller birds' beaks than field oxides formed from polysilicon.

## Claims

1. A method of semiconductor integrated circuit formation comprising:
forming a field oxide by a process CHARACTERIZED BY
forming a layer of amorphous silicon (e.g., 15) overlying a substrate (e.g., 11);
forming a patterned layer (e.g., 17) overlying said layer of amorphous silicon (e.g., 15), said patterned layer exposing portions (e.g., 19) of said layer of amorphous silicon;
substantially completely oxidizing (e.g., 23) said exposed portions of amorphous silicon.

2. The method of claim 1 in which said patterned overlying layer (e.g., 17) is silicon nitride.

3. The method of claim 1 in which said amorphous silicon layer (e.g., 15) is formed at a temperature of 550 °C±10 _{°} C.

4. The method of claim 1 in which an oxide layer (e.g., 13) is formed between said amorphous silicon layer (e.g., 15) and said substrate (e.g., 11 ).

5. The method of claim 1 in which the thickness of said amorphous silicon layer (e.g., 15) is 500-800A.

6. The method of claim 1 in which said substrate (e.g., 11) is also oxidized.
